# EUROPEAN PATENT APPLICATION

(11) **EP 4 607 900 A1**
(43) Date of publication of application: **27.08.2025**
(21) Application number: 23898397.7
(22) Date of filing: 01.12.2023
(51) Int. Cl.: H04M 1/02, H05K 1/14, H05K 5/06, H05K 5/02

(54) **ELECTRONIC DEVICE INCLUDING FLEXIBLE CABLE COVER**

(30) Priority: 02.12.2022 KR 20220166973; 09.01.2023 KR 20230002817
(71) Applicant: Samsung Electronics Co., Ltd., Suwon-si, Gyeonggi-do 16677 (KR)
(72) Inventor: HONG, Jaemin, Suwon-si, Gyeonggi-do 16677 (KR)
(74) Representative: Gulde & Partner
(86) International application number: PCT/KR2023/019720
(87) International publication number: WO 2024/117874

(57) **Abstract**

Disclosed is an electronic device including a flexible cable cover. The foldable electronic device according to various embodiments of the disclosure may include multiple housings including a hinge, coupled to each other to be rotatable by the hinge, and having an inner space for receiving multiple electrical components, and a flexible cable for electrically and mutually connecting the multiple electrical components of the housing. The housing may include a cable hole through which the flexible cable extends, a cable seal for closing one side of the cable hole, the one side being disposed in a first direction, and a cable hole cover which is disposed to cover the other side of the cable hole and at least partially closes the cable hole while holding the flexible cable with respect to the cable hole, the other side being disposed in a second direction opposite the first direction.

## Description

### [Technical Field]

Various embodiments disclosed in this document relate to an electronic device, and more specifically, to an electronic device including a flexible cable cover.

### [Background Art]

The electronic device requires a small profile for portability, and requires a large display area in order to provide a large amount of information to the user. In order to achieve both the small profile and the large display area of the electronic device, various form factors such as foldable are emerging, departing from the conventional rectangular bar-shaped form factor.

An electronic device having a foldable form factor may include multiple housings that are mutually coupled to be rotatable by a hinge. Various electrical components such as a battery, a camera, and a printed circuit board may be positioned in the multiple housings. The electrical components disposed in the multiple housings need to be connected to each other. To this end, the battery may include a flexible cable disposed to pass through the hinge portion.

The electronic device may provide waterproof and dustproof functions that protect the electronic device from foreign substances such as water or dust, in order to improve user convenience and product durability. For waterproofing and dustproofing, in the foldable electronic device, the hinges and each housing coupled to the hinge may be sealed by a seal or a sealant (e.g., waterproof adhesive).

### [Disclosure of Invention]

### [Technical Problem]

In the implementation of waterproofing of a foldable electronic device, a seal or a waterproof adhesive may be disposed in a region of the housing through which a flexible cable passes. However, the flexible cable may flow during the assembly process, thereby deteriorating the waterproof performance of the waterproof adhesive, or forming a gap through which water is introduced due to a phenomenon in which multiple layers included in the flexible cable become separated, which may degrade the waterproof performance.

Various embodiments of the disclosure may provide a cable hole cover that improves waterproof performance and an electronic device including the same.

The foldable electronic device according to various embodiments of the disclosure may include multiple housings including a hinge, coupled to each other to be rotatable by the hinge, and including an inner space for receiving multiple electrical components, and a flexible cable configured to electrically and mutually connect the multiple electrical components of the housings. The housing may include a cable hole formed to allow the flexible cable to pass therethrough, a cable seal configured to close one side of the cable hole positioned in a first direction, and a cable hole cover positioned to cover the other side of the cable hole positioned in a second direction opposite to the first direction, and to at least partially close the cable hole while holding the flexible cable with respect to the cable hole.

In various embodiments, the flexible cable may include a shaping portion that is bent and shaped to be directed from the cable hole toward a direction of the electrical component, and the cable hole cover may include a cable shaping guide surface that is formed on a surface of the cable hole cover facing the first direction and supports the shaping portion of the flexible cable.

In various embodiments, a curvature radius of the cable shaping guide surface may be equal to a curvature radius of the shaping portion of the flexible cable.

In various embodiments, a cable holder that includes an elastic material and holds the flexible cable by pressing the flexible cable against an end of the other side of the cable hole, may be included.

In various embodiments, the housing may include a waterproof member including a resin material that is at least partially filled inside the cable hole, and the cable hole cover may be positioned to cover the resin material from the other side of the cable hole.

In various embodiments, the flexible cable may include multiple layers.

In various embodiments, the cable hole cover may include a pressing protrusion configured to press the resin material with respect to the first direction.

In various embodiments, the flexible cable may include a shaping portion that is bent and shaped to be directed from the cable hole toward a direction of the electrical component, and
the cable hole cover
may include a cable shaping guide surface formed on a surface of the pressing protrusion and supports the shaping portion of the flexible cable.

In various embodiments, the housing may include a screw hole positioned around the cable hole and formed in the first direction and the cable hole cover may include a fastening hole formed at a position corresponding to the screw hole.

In various embodiments, the cable hole cover may include a screw that passes through the fastening hole and is fastened to the screw hole, and the cable hole cover may press the resin material by thrust generated by fastening of the screw to the screw hole.

In various embodiments, a guide vane configured to transfer the resin material inside the cable hole in a direction in which the flexible cable is positioned, may be included.

In various embodiments, the guide vane may be disposed with an inclination to be directed toward a region of the cable hole cover overlapping the flexible cable

In various embodiments, the guide vane may be positioned laterally with respect to the first direction relative to a center of the cable hole cover.

As a cable hole cover of a foldable electronic device that includes multiple housings including an inner space for receiving multiple electrical components, and a flexible cable configured to electrically and mutually connect the multiple electrical components of the housings, in which the housings include a cable hole formed to allow the flexible cable to pass therethrough, a cable seal configured to close one side of the cable hole in a first direction, and a waterproof member including a resin material that at least partially fills an interior of the cable hole, the cable hole cover according to various embodiments of the disclosure may be configured to be positioned to cover the other side of the cable hole and to at least partially close the cable hole while holding the flexible cable with respect to the cable hole.

In various embodiments, the flexible cable may include a shaping portion that is bent and shaped to be directed from the cable hole toward a direction of the electrical component, and the cable hole cover may include a cable shaping guide surface that is formed on a surface of the cable hole cover facing the first direction and supports the shaping portion of the flexible cable.

In various embodiments, a curvature radius of the cable shaping guide surface may be equal to a curvature radius of the shaping portion of the flexible cable.

In various embodiments, a pressing protrusion configured to press the resin material with respect to the first direction, may be included.

In various embodiments, a guide vane that is disposed to transfer the resin material inside the cable hole in a direction in which the flexible cable is positioned, may be included.

In various embodiments, the guide vane may be disposed with an inclination to be directed toward a region of the cable hole cover overlapping the flexible cable

In various embodiments, the guide vane may be positioned laterally with respect to the first direction relative to a center of the cable hole cover.

According to various embodiments disclosed in this document, a cable hole cover may improve waterproof performance at the cable hole portion of the electronic device by maintaining a constant shaping curvature of a flexible cable, and guiding a waterproof adhesive to be uniformly applied by pressing and transferring the waterproof adhesive.

### [Brief Description of Drawings]

In connection with the description of the drawings, the same or similar reference numerals may be used for the same or similar constituent elements.
FIG. 1 is a block diagram of an electronic device in a network environment according to various embodiments.
FIGS. 2A to 2F illustrate a portable electronic device having a housing structure of an in-folding type according to an embodiment.
FIG. 3A is an exploded perspective view illustrating a rear surface of a foldable electronic device according to various embodiments of the disclosure.
FIG. 3B is an internal plan view illustrating a rear surface of a foldable electronic device according to various embodiments of the disclosure.
FIG. 4A is an enlarged plan view illustrating a part of a housing of a foldable electronic device according to various embodiments of the disclosure.
FIG. 4B is a cross-sectional view illustrating a part of a housing of a foldable electronic device according to various embodiments of the disclosure.
FIG. 4C is a top and bottom plan view illustrating a cable hole cover according to various embodiments of the disclosure.
FIG. 5A is a bottom plan view illustrating a cable hole cover according to various embodiments.
FIG. 5B is an enlarged view illustrating an operation of a cable hole cover according to various embodiments.
FIG. 5C is a schematic diagram illustrating a waterproof member of a foldable electronic device according to a comparative example.
FIG. 5D is a schematic diagram illustrating a process of applying a waterproof member of a foldable electronic device according to an embodiment of the disclosure.

### [Mode for the Invention]

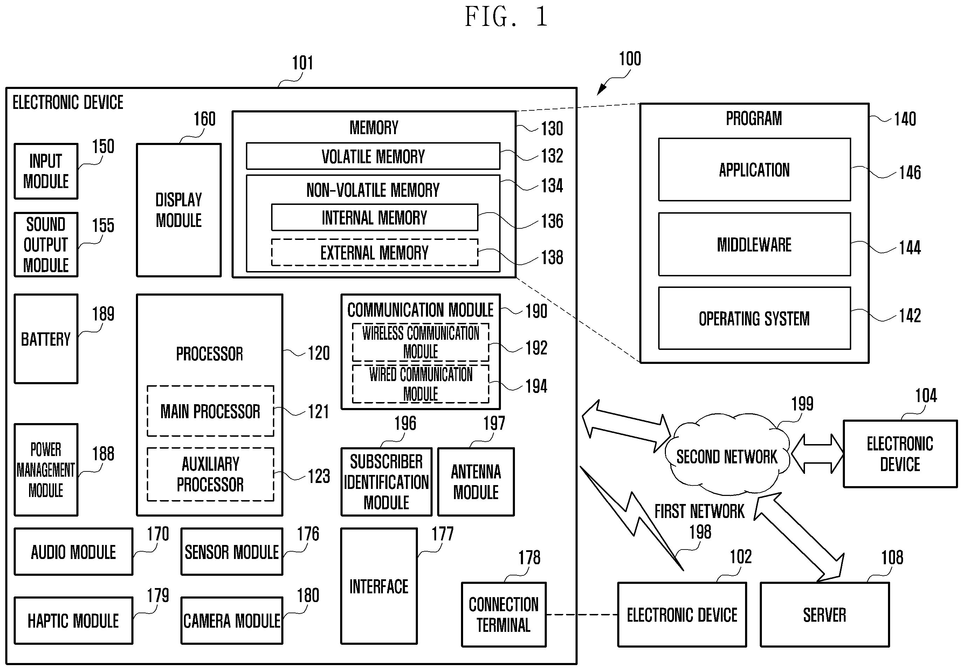

FIG. 1 is a block diagram illustrating an electronic device 101 in a network environment 100 according to various embodiments. Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra-low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

According to various embodiments, a portable electronic device (e.g., the electronic device 101 of FIG. 1) may have a foldable housing that is divided into two housings about a folding axis. A first portion of a display (e.g., a flexible display) may be disposed on a first housing, and a second portion of the display may be disposed on a second housing. The foldable housing may be implemented in an in-folding manner, in which the first portion and the second portion face each other when the portable electronic device is folded. Alternatively, the foldable housing may be implemented in an out-folding manner, in which the first portion and the second portion face opposite directions when the portable electronic device is folded. The surface where the first and second portions of the display are disposed may be defined as a front surface of the portable electronic device, the opposite surface may be defined as a rear surface, and the surface surrounding the space between the front and rear surfaces may be defined as a side surface of the portable electronic device.

According to the embodiments described in this document, the case of in-folding, in which the first portion of the display on the first housing is disposed to face the second portion of the display on the second housing when the display of the portable electronic device is folded, has been illustrated and described as an example. However, in some embodiments, the same configuration may also apply to an out-folding case in which the first portion of the display on the first housing (210) is disposed to face a direction opposite to that of the second portion of the display on the second housing when the display is folded. Additionally, some embodiments may be applied to multi-foldable electronic devices in which in-folding is combined with in-folding, in-folding is combined with out-folding, or out-folding is combined with out-folding.

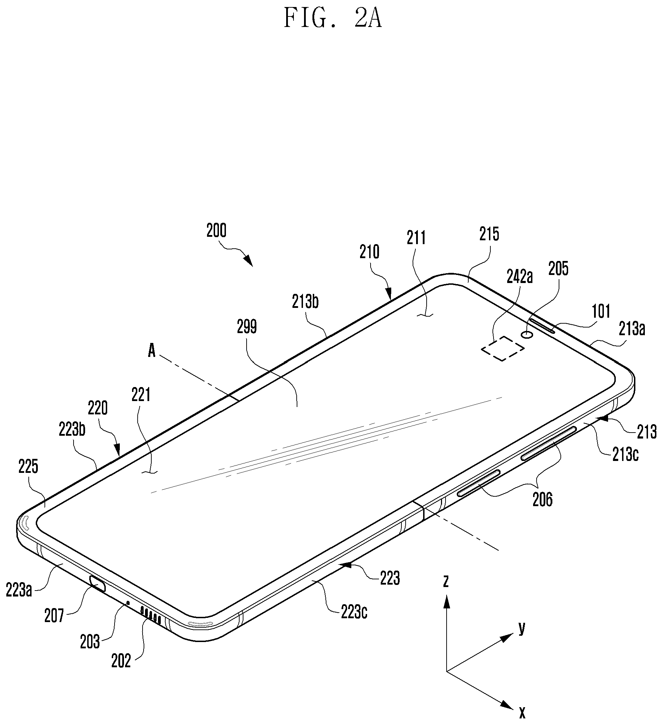

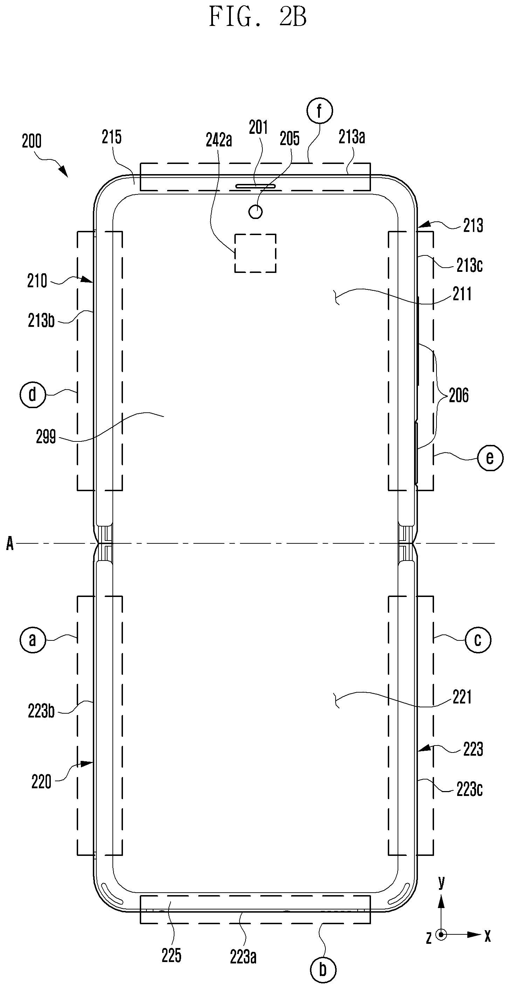

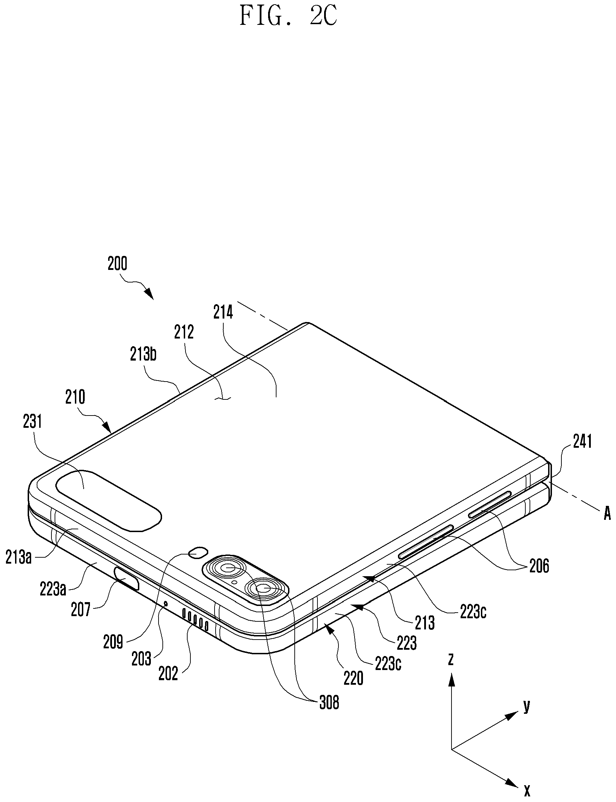

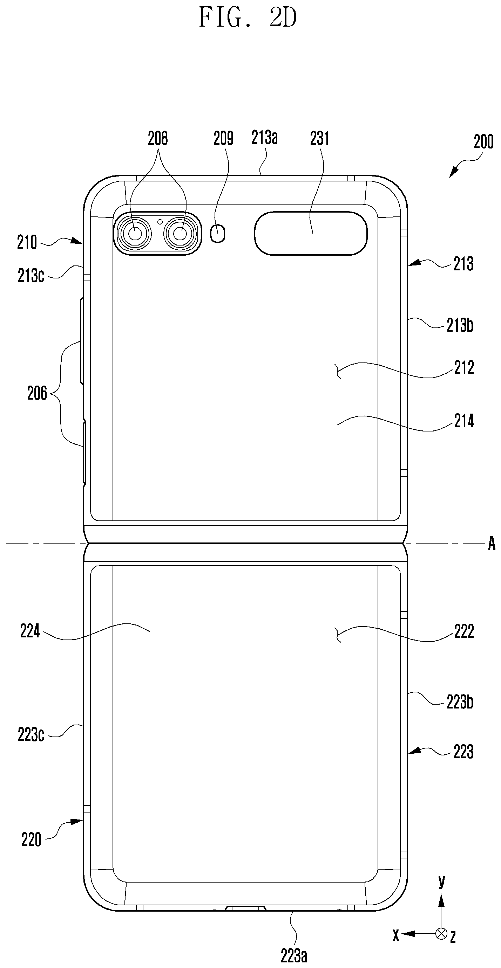

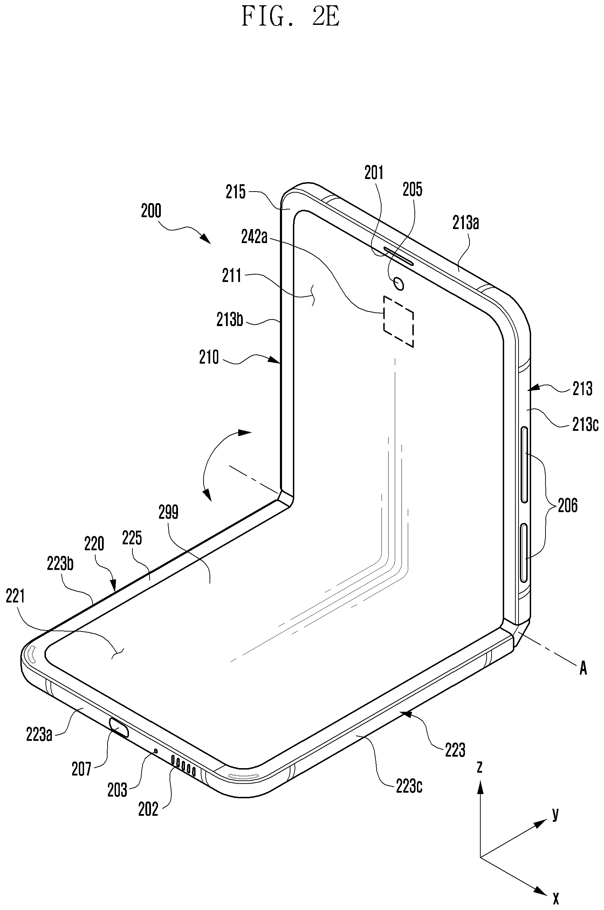

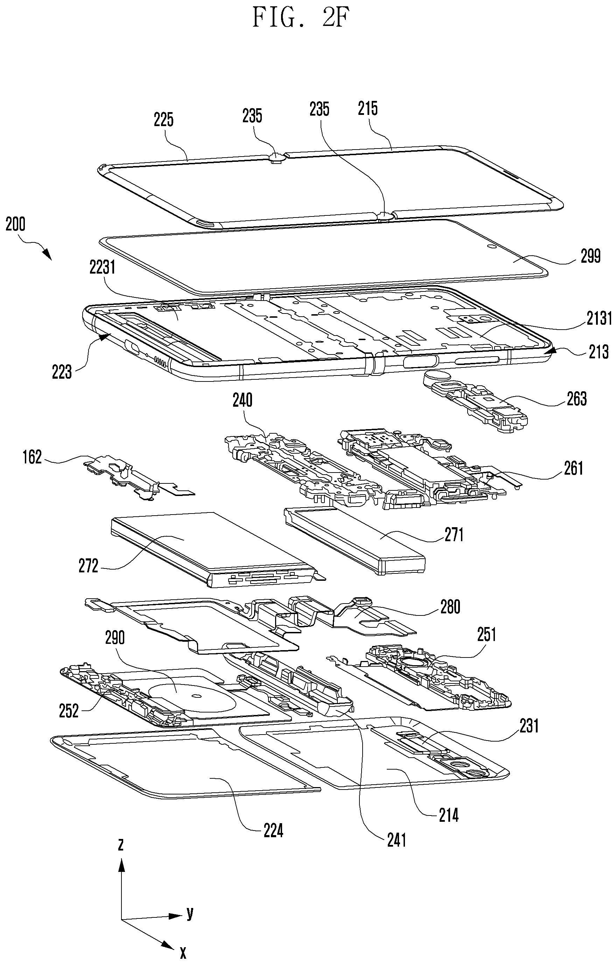

FIGS. 2A to 2F illustrate a portable electronic device having an in-folding type housing structure, according to an embodiment. Specifically, FIGS. 2A and 2B are illustrate the front of the electronic device in an unfolded state according to certain embodiments of the disclosure. FIG. 2C is a plan view illustrating the back of the electronic device in an unfolded state according to certain embodiments of the disclosure. FIG. 2D is a perspective view of the electronic device in a folded state according to certain embodiments of the disclosure. FIG. 2E is a perspective view of the electronic device in an intermediate state according to certain embodiments of the disclosure. FIG. 2F is an exploded perspective view of the electronic device according to certain embodiments of the disclosure.

Referring to FIGS. 2A to 2F, a portable electronic device 200 (e.g., the electronic device 101 in FIG. 1) may include a first housing 210, a second housing 220, a hinge assembly 240 interconnecting the first housing 210 and the second housing 220 such that the second housing 220 is rotatable relative to the first housing 210, a flexible or foldable display 299 disposed in a space defined by the foldable housings 210 and 220, and a sensor module (e.g., the sensor module 176 in FIG. 1).

The display 299 may be disposed from the first housing 210 to the second housing 220 across the hinge assembly 240. The display 299 may be divided into a first display area 211 disposed in the inner space of the first housing 210 and a second display area 221 disposed in the inner space of the second housing 220 with reference to the folding axis A. The sensor module (e.g., an illuminance sensor) may be disposed under a sensor area (or a light transmission area) 242a of the first display area 211 in a plan view. The location and/or size of the sensor area 242a in the first display area 211 may be determined by the location and/or size of the illuminance sensor disposed thereunder. For example, the size (e.g., the diameter) of the sensor area 242a may be determined based on a field of view (FOV) of the illuminance sensor. In an embodiment, the sensor area 242a may be configured to have a lower pixel density and/or a lower wiring density than that in the periphery thereof to improve light transmittance. In some embodiments, the display 299 may include a transparent material and a protective layer 298 that protects a panel layer from external foreign substances and impact.

The hinge assembly 240 may be implemented in an in-folding type which causes the two display areas 211 and 221 to face each other when the portable electronic device 200 is switched from the unfolded state (e.g., the state in FIG. 2A) to the folded state (e.g., the state in FIG. 2C). For example, when the electronic device 200 is in the unfolded state, the two display areas 211 and 221 may face substantially the same direction. As the state is changed from the unfolded state to the folded state, the two display areas 211 and 221 may be rotated to a direction in which the two display areas face each other. The hinge assembly 240 may be configured such that the foldable housings 210 and 220 have resistance to rotation. When an external force exceeding the resistance is applied to the foldable housings 210 and 220, the foldable housings 210 and 220 may be rotated.

Based on the angle formed between the two display areas 211 and 221, the state of the electronic device 200 may be defined. For example, the state of the electronic device 200 may be defined as an unfolded (unfolded, flat, or open) state when the angle between the two display areas 211 and 221 is about 180 degrees. When the angle between the two display areas 211 and 221 is between about 0 and 10 degrees, the state of the portable electronic device 200 may be defined as a folded or closed state. When the two display areas 211 and 221 form an angle greater than the angle in the folded state and smaller than the angle in the unfolded state (e.g., between about 10 degrees and 179 degrees), the state may be defined as an intermediate state (in other words, a partially folded or partially unfolded state) as illustrated in FIG. 2E.

An active area in which visual information (e.g., text, image, or icon) is to be displayed on the display 299 may be determined based on the state of the portable electronic device 200. For example, when the electronic device 200 is in the intermediate state, the active area may be determined as the first display area 211 or the second display area 221. Of the first display area 211 and the second display area 221, an area having a relatively smaller movement may be determined as the active area. For example, when the user holds one housing of the electronic device 200 with one hand and opens another housing with a finger (e.g., the thumb) of the same hand or the other hand, the electronic device 200 may be switched from the folded state to the intermediate state, and as a result, in the electronic device 200, the display area of the held housing (i.e., the housing having a relatively smaller movement) may be determined as the active area. When the portable electronic device 200 is in the unfolded state, the entire area of the display 299 (e.g., both the first display area 211 and the second display area 221) may be determined as the active area.

According to various embodiments, in the unfolded state, the first housing 210 may include a first surface (a first display area) 211 oriented in a first direction (e.g., the front direction) (the z-axis direction) and a second surface 212 oriented in a second direction (e.g., a rear direction) (the -z-axis direction) in which the second surface faces away from the first surface 211. In the unfolded state, the second housing 220 may include a third surface (a second display area) 221 oriented in the first direction (e.g., the z-axis direction) and a fourth surface 222 oriented in the second direction (e.g., the -z-axis direction). The electronic device 200 may be operate such that, in the unfolded state, the first surface 211 of the first housing 210 and the third surface 221 of the second housing 220 are oriented in the same first direction (e.g., the z-axis direction), and, in the folded state, the first surface 211 and the third surface 221 face each other. The electronic device 200 may be operated such that, in the unfolded state, the second surface 212 of the first housing 210 and the fourth surface 222 of the second housing 220 are oriented in the same second direction (the -z-axis direction), and, in the folded state, the second surface 212 and the fourth surface 222 face away from each other.

According to various embodiments, the first housing 210 may include a first side frame 213 forming at least a portion of the exterior of the electronic device 200 and a first rear cover 214 coupled to the first side frame 213 and forming at least a portion of the second surface 212 of the electronic device 200. According to an embodiment, the first side frame 213 may include a first side surface 213a, a second side surface 213b extending from one end of the first side surface 213a, and a third side surface 213c extending from the other end of the first side surface 213a. According to an embodiment, the first side frame 213 may be formed in a rectangular (e.g., square or rectangular) shape via the first side surface 213a, the second side surface 213b, and the third side surface 213c.

A portion of the first side frame 213 may be formed of a conductor. For example, referring to FIG. 2B, a portion ⓕ of the first side surface 213a, a portion ⓓ of the second side surface 213b, and a portion ⓔ of the third side surface 213c may be formed of a metal material. The conductors may be electrically connected to grip sensors (not illustrated), respectively, which are disposed in the inner space of the first housing 210 adjacent thereto. A processor may measure the capacitances formed between the conductors and a ground (e.g., a ground of a main printed circuit board) via the grip sensors, and may recognize that a dielectric body (e.g., a finger, a palm, or a face) is close to (or in contact with) the first housing 210 and a place that is contact with the dielectric body in the first housing 210 (e.g., the first side surface 213a, the second side surface 213b, or the third side surface 213c) based on the measured capacitance values.

According to various embodiments, the second housing 220 may include a second side frame 223 forming at least a portion of the exterior of the electronic device 200 and a second rear cover 224 coupled to the second side frame 223 and forming at least a portion of the fourth surface 222 of the electronic device 200. According to an embodiment, the second side frame 223 may include a fourth side surface 223a, a fifth side surface 223b extending from one end of the fourth side surface 223a, and a sixth side surface 223c extending from the other end of the fourth side surface 223a. According to an embodiment, the second side frame 223 may be formed in a rectangular shape via the fourth side surface 223a, the fifth side surface 223b, and the sixth side surface 223c.

A portion of the second side frame 223 may be formed of a conductor. For example, referring to FIG. 2B, a portion ⓑ of the fourth side surface 223a, a portion ⓐ of the fifth side surface 223b, and a portion ⓒ of the sixth side surface 223c may be formed of a metal material. The conductors may be electrically connected to grip sensors (not illustrated), respectively, which are disposed in the inner space of the second housing 220 adjacent thereto. A processor may measure the capacitance formed between the conductors and a ground (e.g., a ground of a main printed circuit board) via the grip sensors, and may recognize that a dielectric body is close to (or in contact with) the second housing 220 and a place that is contact with the dielectric body in the second housing 220 (e.g., the fourth side surface 223a, the fifth side surface 223b, or the sixth side surface 223c) based on the measured capacitance values.

According to various embodiments, the pair of housing structures 210 and 220 are not limited to the illustrated shape and assembly, but may be implemented by other shapes or other combinations and/or assemblies of components. For example, the first side frame 213 and the first rear cover 214 may be integrally formed, and the second side frame 223 and the second rear cover 224 may be integrally formed.

According to various embodiments, the first rear cover 214 and the second rear plate 224 may be formed of one or a combination of two or more of, for example, coated or colored glass, ceramic, polymer, or metal (e.g., aluminum, stainless steel (STS), or magnesium).

According to various embodiments, the electronic device 200 may include a first protective cover 215 (e.g., a first protective frame or a first decorative member) coupled along the edges of the first housing 210. The electronic device 200 may include a second protective cover 225 (e.g., a second protective frame or a second decorative member) coupled along the edges of the second housing 220. According to an embodiment, the first protective cover 215 and the second protective cover 225 may be formed of a metal or polymer material.

According to various embodiments, the electronic device 200 may include a sub-display 231 (e.g., second display) disposed separately from the display 299. According to an embodiment, the sub-display 231 is disposed to be at least partially exposed on the second surface 212 of the first housing 210, so that when the electronic device 200 is in a folded state, the sub-display 231 may display state information of the electronic device 200. According to an embodiment, the sub-display 231 may be disposed to be visible from the outside through at least a partial area in the first rear cover 214. In some embodiments, the sub-display 231 may be disposed on the fourth surface 222 of the second housing 220. In this case, the sub-display 231 may be disposed to be visible from the outside through at least one area in the second rear cover 224.

According to various embodiments, the electronic device 200 may include at least one of an input device 203, a sound output device 201 or 202, a camera module 205 or 208, a key input device 206, a connector port 207, and a sensor module (not illustrated). In an embodiment, the sensor module (e.g., the sensor module 176 in FIG. 1), and the camera 205 may be disposed below the display 299 in a plan view.

According to various embodiments, the electronic device 200 may be operated to maintain the intermediate state via the hinge assembly 240. In this case, the electronic device 200 may control the display 299 to display different contents on the display area corresponding to the first surface 211 and the display area corresponding to the third surface 221, respectively.

Referring to FIG. 2F, the electronic device 200 according to various embodiments may include a first side frame 213, a second side frame 223, and a hinge assembly 240 rotatably connecting the first side frame 213 and the second side frame 223 to each other. According to an embodiment, the electronic device 200 may include a first support plate 2131 at least partially extending from the first side frame 213 and a second support plate 2231 at least partially extending from the second side frame 223. According to an embodiment, the first support plate 2131 may be integrally formed with the first side frame 213 or may be structurally coupled to the first side frame 213. Similarly, the second support plate 2231 may be integrally formed with the second side frame 223 or may be structurally coupled to the second side frame 223. According to an embodiment, the electronic device 200 may include a display 299 disposed to be supported by the first support plate 2131 and the second support plate 2231. According to an embodiment, the electronic device 200 may include a first rear cover 214 coupled to the first side frame 213 and providing a first space with the first support plate 2131, and a second rear cover 224 coupled to the second side frame 223 and providing a second space with the second support plate 2231. In some embodiments, the first side frame 213 and the first rear cover 214 may be integrally formed. In some embodiments, the second side frame 223 and the second rear cover 224 may be integrally formed. According to an embodiment, the electronic device 200 may include a first housing 210 provided via the first side frame 213, the first support plate 2131, and the first rear cover 214. According to an embodiment, the electronic device 200 may include a second housing 220 provided via the second side frame 223, the second support plate 2231, and the second rear cover 224.

Although not illustrated, the hinge assembly 240 may include a first arm structure coupled to the first housing 210 (e.g., the first support plate 2131), a second arm structure coupled to the second housing 220 (e.g., the second support plate 2231), and a detent structure that is in physical contact with the first arm structure and the second arm structure such that the first housing 210 and the second housing 220 have resistance to rotation. The foldable housings 210 and 220 may have resistance to rotation by the contact force of the detent structure (e.g., the force pushing the first arm structure and the second arm structure).

According to various embodiments, the electronic device 200 may include a first board assembly 261 (e.g., a main printed circuit board), a camera assembly 263, a first battery 271, or a first bracket 251 disposed in a first space between the first side frame 213 and the first rear cover 214. According to an embodiment, the camera assembly 263 may include a plurality of cameras (e.g., the camera modules 205 and 208 in FIGS. 2A and 2C), and may be electrically connected to the first board assembly 261. According to an embodiment, the first bracket 251 may provide a support structure for supporting the first board assembly 261 and/or the camera assembly 263 and improved rigidity. According to an embodiment, the electronic device 200 may include a second board assembly 262 (e.g., a sub printed circuit board), an antenna 290 (e.g., a coil member), a second battery 272, or a second bracket 252 disposed in a second space between the second side frame 223 and the second rear cover 224. According to an embodiment, the electronic device 200 may include a wiring member 280 (e.g., a flexible printed circuit board (FPCB)) disposed to extend from the first board assembly 261 across the hinge assembly 240 to a plurality of electronic components (e.g., the second board assembly 262, the second battery 272, or the antenna 290) disposed between the second side frame 223 and the second rear cover 224 and to provide an electrical connection.

According to various embodiments, the electronic device 200 may include a hinge cover 241, which is configured to support the hinge assembly 240, exposed to the outside when the electronic device 200 is in the folded state, and introduced into the first space and the second space to be invisible from the outside when the electronic device 200 is in the unfolded state.

According to various embodiments, the electronic device 200 may include a first protective cover 215 coupled along the edges of the first side frame 213. According to an embodiment, the electronic device 200 may include a second protective cover 225 coupled along the edges of the second side frame 223. In the display 299, the edges of the first display area 211 may be protected by the first protective cover 215. The edges of the second display area 221 may be protected by the second protective cover 225. Protective caps 235 may be disposed in an area corresponding to the hinge assembly 240 to protect bent portions of the edges of the display 299.

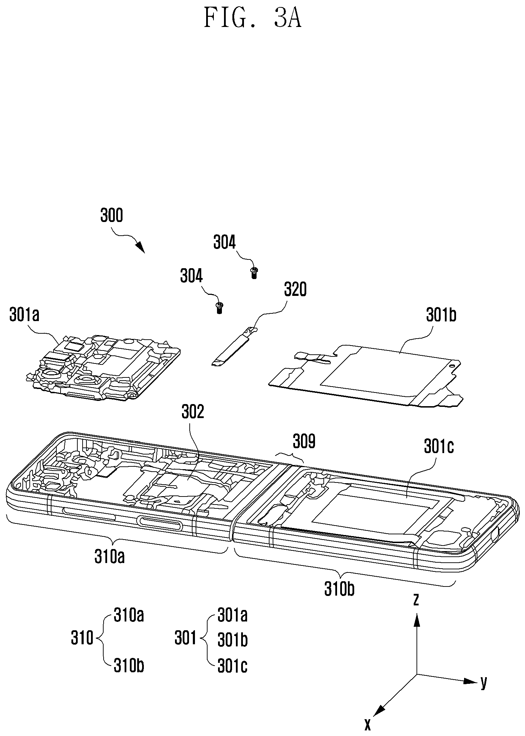

FIG. 3A is an exploded perspective view illustrating a rear surface of a foldable electronic device 300 according to various embodiments of the disclosure.

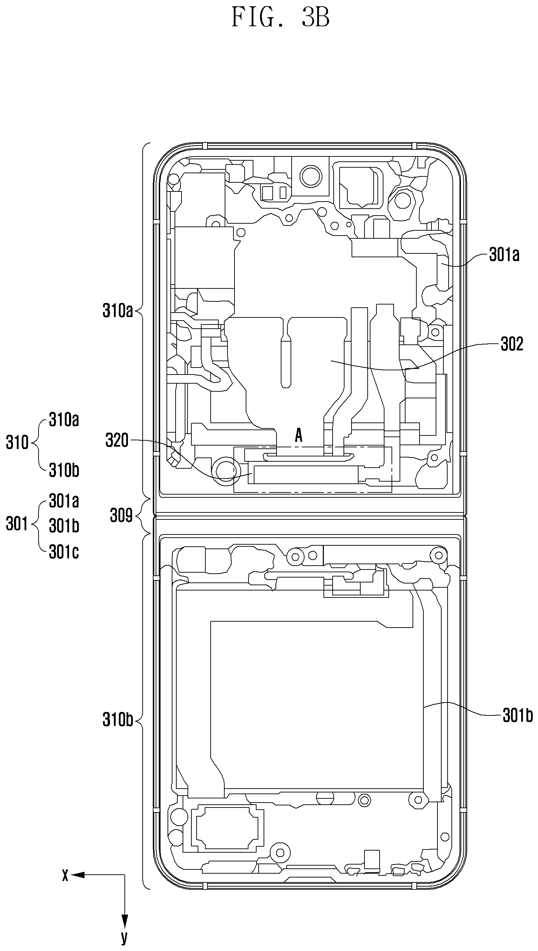

FIG. 3B is an internal plan view illustrating a rear surface of a foldable electronic device 300 according to various embodiments of the disclosure.

With reference to FIGS. 3A and 3B, a foldable electronic device 300 (e.g., the electronic device 101 in FIG. 1, or the foldable electronic device 200 in FIGS. 2A to 2F) may include multiple housings 310a and 310b (e.g., the first housing 210 and the second housing 220 in FIGS. 2A to 2F). The multiple housings 310a and 310b may respectively include electrical components, for example, a main printed board assembly (main PBA), a battery, an NFC antenna, and/or a sub-board. The multiple housings 310a and 310b may be rotatably coupled by a hinge portion 309 (e.g., the hinge assembly 240 in FIG. 2A) and may be foldable or unfoldable.

In various embodiments, the foldable electronic device 300 may include a flexible cable 302. The flexible cable 302 may be a member for mutually and electrically connecting an electrical component positioned in one of the multiple housings 310a and 310b with another electrical component positioned in the other one of the multiple housings 310a and 310b. For example, the flexible cable 302 may be a member that mutually connects the main printed board assembly of the first housing 310a with the battery, NFC antenna, and/or sub-board of the foldable electronic device 300. In various embodiments, the flexible cable 302 may include, for example, a ribbon cable, a flexible flat cable (FFC), and/or a flexible printed circuit (FPC). In various embodiments, the flexible cable 302 may have multiple layers. For example, the FPC may include a multilayer FPC in which multiple conductor layers are stacked. The multilayer FPC may enable multiple circuits to be connected while occupying a smaller area compared to a single-layer cable.

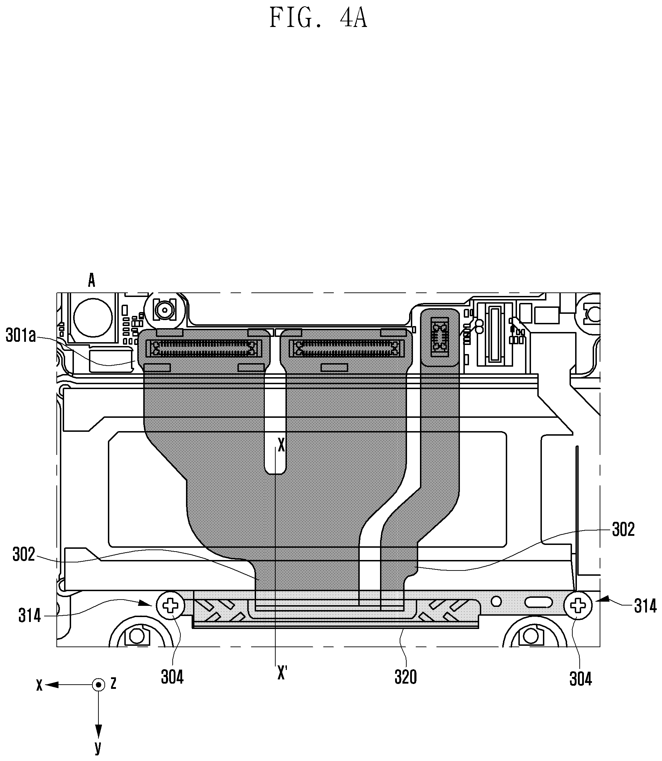

FIG. 4A is an enlarged plan view illustrating a part of a housing 310 of the foldable electronic device 300 according to various embodiments of the disclosure.

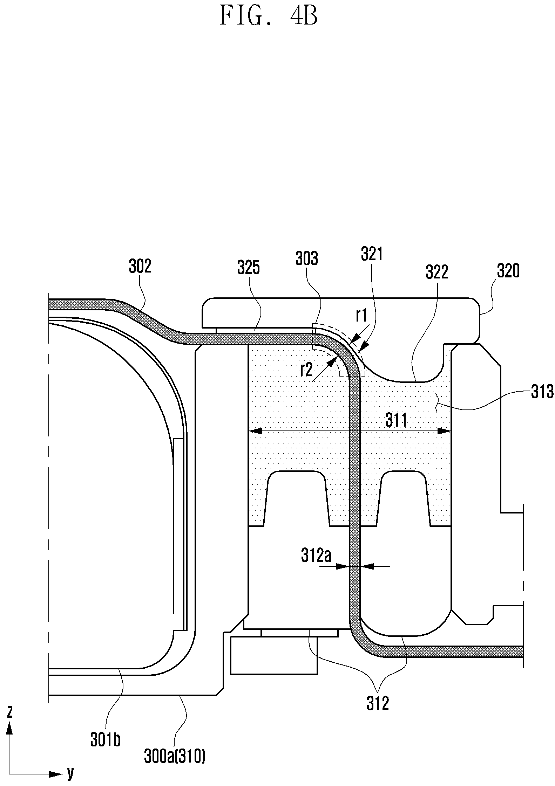

FIG. 4B is a cross-sectional view illustrating a part of the housing 310 of the foldable electronic device 300 according to various embodiments of the disclosure.

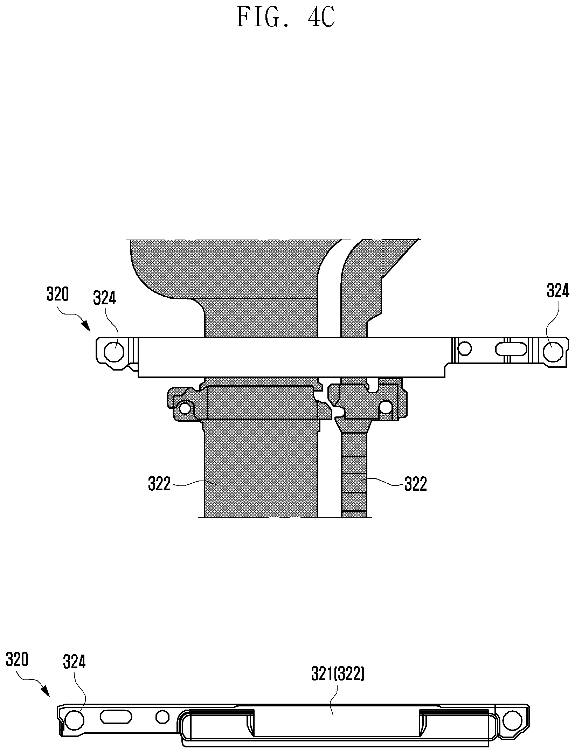

FIG. 4C is a top and bottom plan view illustrating a cable hole cover 320 according to various embodiments of the disclosure.

FIG. 4A is an enlarged view of region A in FIG. 3B, and the cross-section in FIG. 4B is a surface cut taken along direction X-X' in FIG. 4A.

With reference to FIGS. 4A and 4B, the housing 310 of the foldable electronic device 300 may include a cable hole 311. The cable hole 311 may be a through-hole formed in the housing 310 to allow the flexible cable 302 to pass therethrough. The cable hole 311 may be formed in a region of the housing 310 adjacent to the hinge. Accordingly, the flexible cable 302 may pass through the cable hole 311 formed in the first housing 310a and be connected to the electrical components disposed with the hinge portion interposed therebetween inside the foldable electronic device 300 (not illustrated).

In various embodiments, on opening at one side (e.g., the -z direction) of the cable hole 311 may be closed by a cable seal 312. The cable seal 312 (e.g., a cable sealing member) may include an elastic material, for example, a material such as rubber, NBR, and/or TPU. The cable seal 312 may have a size and shape corresponding to the size and shape of the cable hole 311, and may have a gap 312a (e.g., a through-hole) through which the cable passes.

The flexible cable 302 passing through the cable hole 311 may have at least one shaping portion 303. The shaping portion 303 may be a bent portion allowing the cable to extend in a direction (e.g., the -y direction in the drawing) in which an electrical component is positioned inside the housing 310 after passing through the cable hole 311. In some embodiments, the shaping portion 303 may be naturally bent for connection to an electrical component during the assembly process, or may be permanently shaped into a bent form by separate bending processing. In some embodiments, the shaping portion 303 may be positioned on a side (e.g., the z direction) facing the cable seal 312 of the cable hole 311.

In various embodiments, the cable hole 311 may include a waterproof member 313 that at least partially fills an interior of the cable hole 311. The waterproof member 313 may include, for example, a resin material such as epoxy, polyurethane, silicone, and/or phenol resin. The above-described resin material may be injected into the interior of the cable hole 311 and cured, thereby providing waterproofing to the cable hole 311.

With reference to FIGS. 4A to 4C, in various embodiments, the foldable electronic device 300 may include a cable hole cover 320. The cable hole cover 320 may be a member that at least partially closes an opening at the other side (e.g., in a direction opposite to the y-axis in the drawing) of the cable hole cover 320 in the housing 310. For example, the cable hole cover 320 may be a member that covers at least a portion of an opening at the other side (e.g., in the direction opposite to the y-axis in the drawing) of the cable hole cover 320. For example, the cable hole cover 320 may include a through-hole (not illustrated). For example, the cable hole cover 320 may include a through-hole (not illustrated) that passes from one surface (e.g., a surface facing in the direction opposite to the z-direction in the drawing) to the other surface (e.g., a surface facing in the z-direction in the drawing) of the cable hole cover 320. In various embodiments, the housing 310 may include a screw hole 314 positioned around the cable hole 311, and the cable hole cover 320 may include a fastening hole 324 formed at a position corresponding to the screw hole 314. The cable hole cover 320 may be fastened to the housing 310 by a screw 304 that passes through the fastening hole 324 and is fastened to the screw hole 314. The screw hole 314 may be formed in a downward direction (e.g., in a direction opposite to the z-direction in the drawing).

In various embodiments, the cable hole cover 320 may include a cable holder 325. The cable holder 325 may be a member that holds the flexible cable 302 by pressing the flexible cable 302 against the other side of the cable hole 311 where the cable hole cover 320 is positioned. The cable hole cover 320 may include a rigid material such as a polymer compound (e.g., polycarbonate (PC)), a metal (e.g., iron, stainless steel, aluminum, magnesium), carbon fiber, and/or glass (e.g., glass fiber). The cable holder 325 may include an elastic material such as foam resin (e.g., sponge), rubber, and/or silicone.

In various embodiments, the cable hole cover 320 may include a shaping guide surface 321. The shaping guide surface 321 may be a portion that maintains the shaped state of the flexible cable 302 and supports the shaping portion 303 of the flexible cable 302. For example, the shaping guide surface 321 may be formed at a portion adjacent to the shaping portion 303 of the flexible cable 302 at a lower part of the cable hole cover 320 (e.g., in the direction opposite to the z-direction in the drawing). A curvature R1 of the shaping guide surface 321 may be equal to or similar to a curvature R2 of the shaping portion 303 of the flexible cable 302.

When the flexible cable 302 is shaped, a variation in the curvature radius of the shaping portion 303 may occur. The variation in the curvature radius may affect a reach length of the flexible cable 302. During assembly of the foldable electronic device 300, due to the variation in the reach length of the flexible cable 302, an operator or an operating robot may apply a force to stretch or compress the flexible cable 302. Accordingly, stress may be applied to the flexible cable 302, and the flexible cable 302 may be damaged by the stress, or multiple layers included in the flexible cable 302 may be separated, thereby allowing an external contaminant such as water to enter between the multiple layers of the cable. In addition, due to the force applied to the flexible cable 302, the waterproof member 313 that provides waterproofing inside the cable hole 311 may be opened by the movement of the flexible cable 302, thereby degrading the waterproof performance of the foldable electronic device 300. The cable holder 325 of the disclosure may reduce the movement of the flexible cable 302 by holding the flexible cable 302, thereby reducing the possibility that the flexible cable 302 is damaged or that a waterproof defect occurs due to the waterproof member 313 being opened. In addition, the shaping guide surface 321 of the disclosure may reduce the variation in the reach length of the flexible cable 302 by maintaining the curvature radius of the shaping portion 303 of the flexible cable 302 constant.

In various embodiments, the cable hole cover 320 may include a pressing protrusion 322. The pressing protrusion 322 may be formed on a lower surface (e.g., a surface facing a direction opposite to the z-axis) of the cable hole cover 320. The pressing protrusion 322 may press the waterproof member 313 inside the cable hole 311. For example, the pressing protrusion 322 may press the waterproof member 313 in a resin state filled in the cable hole 311. The waterproof member 313 pressed by the pressing protrusion 322 may apply pressure to the cable. The pressure of the waterproof member 313 may reduce defects in which the respective layers of the flexible cable 302 having multiple layers are separated from each other, and may improve the waterproof performance of the foldable electronic device 300. In various embodiments, the cable hole cover 320 may be fastened to the housing 310 by the screw 304, and the pressing protrusion 322 may press the waterproof member 313 by thrust according to fastening of the screw 304.

In various embodiments, the pressing protrusion 322 may be disposed to be adjacent to the shaping portion 303 of the flexible cable 302, and the shaping guide surface 321 may be formed on a surface of the pressing protrusion 322 facing the shaping portion 303. For example, the surface of the pressing protrusion 322 facing the shaping portion 303 may be processed to have the curvature R1 that is equal to or similar to the curvature R2 of the shaping portion 303.

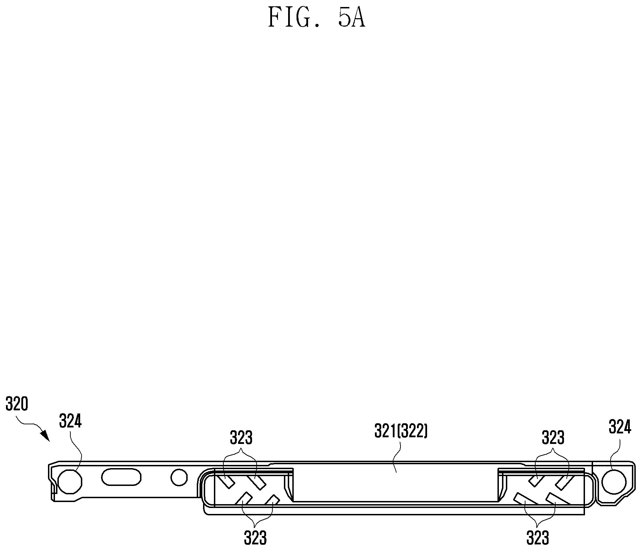

FIG. 5A is a bottom plan view illustrating the cable hole cover 320 according to various embodiments.

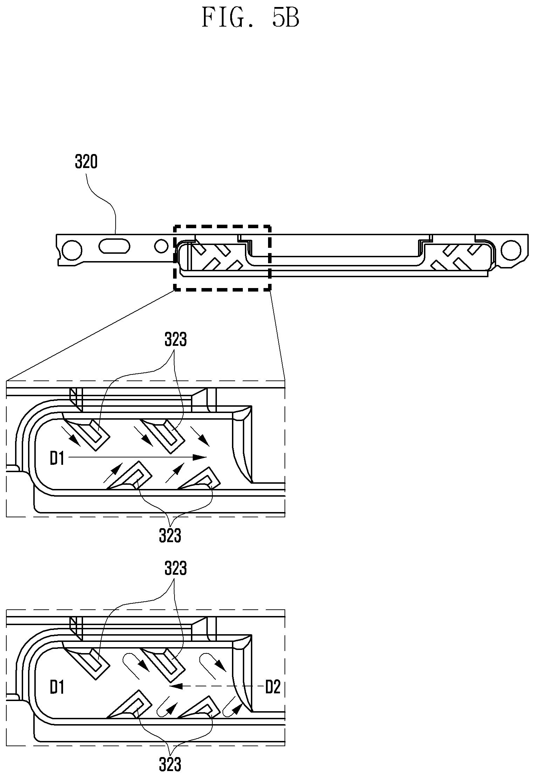

FIG. 5B is an enlarged view illustrating an operation of the cable hole cover 320 according to various embodiments.

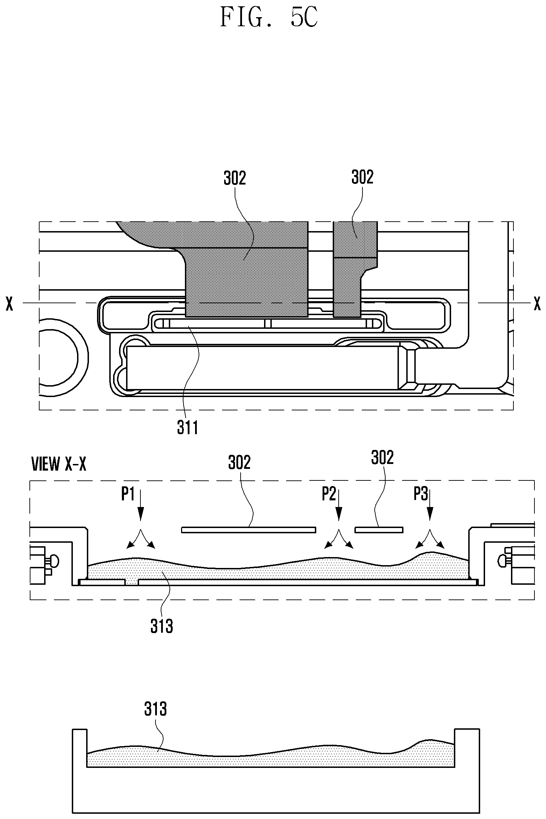

FIG. 5C is a schematic diagram illustrating the waterproof member 313 of a foldable electronic device according to a comparative example.

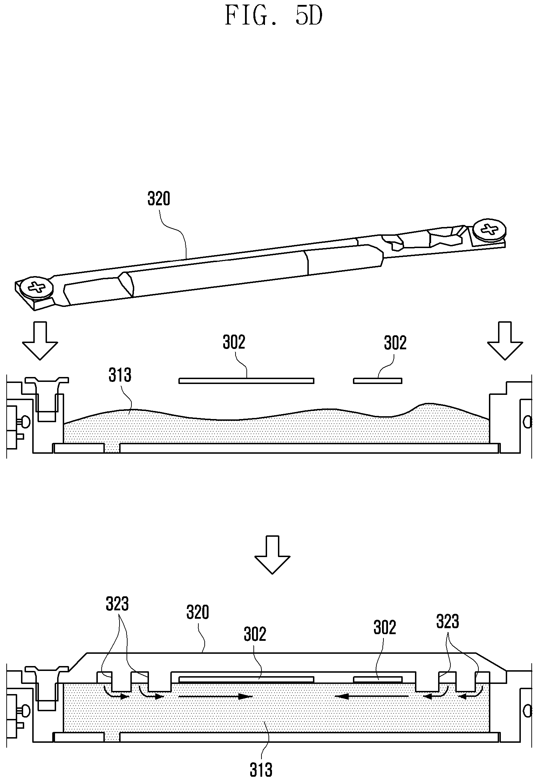

FIG. 5D is a schematic diagram illustrating a process of applying the waterproof member 313 of the foldable electronic device 300 according to an embodiment of the disclosure.

FIG. 5B is an enlarged view of region B in FIG. 5A.

With reference to FIGS. 5A and 5B, the cable hole cover 320 may include a guide vane 323. The guide vane 323 may be a portion that transfers the waterproof member 313 in a resin state in a direction in which the flexible cable 302 is positioned. In various embodiments, the flexible cable 302 may be disposed to overlap a central portion of the cable hole cover 320, and the guide vane 323 may be disposed at a side portion of the cable hole cover 320. For example, the pressing protrusion 322 and/or the shaping guide surface 321 may be positioned at the central portion of the cable hole cover 320, and the guide vane 323 may be positioned at both side portions of the pressing protrusion 322 and the shaping guide surface 321.

In various embodiments, the guide vane 323 may be directed inward of the cable hole cover 320, and may be disposed with an inclination to be directed toward a region of the cable hole cover 320 overlapping the flexible cable 302. For example, the guide vane 323 may be disposed with an inclination to be directed toward the pressing protrusion 322 and/or the shaping guide surface 321.

With reference to FIG. 5B, due to the inclination of the above-described guide vane 323, the waterproof member 313 in a resin state may be transferred inside the cable hole 311 in the direction in which the flexible cable 302 is positioned. The waterproof member 313 in a resin state may easily flow in a forward direction D1 with respect to the guide vane 323, i.e., toward the central region of the cable hole cover 320 overlapping the flexible cable 302, whereas the flow in a reverse direction D2 may be hindered due to a collision C with the guide vane 323. Accordingly, the waterproof member 313 in a resin state may be transferred in the direction of the flexible cable 302.

With reference to FIG. 5C, in a comparative example of a foldable electronic device that does not include the cable hole cover 320 and the guide vane 323, points in the cable hole 311 where the waterproof member 313 in a resin state may be injected may be limited to points P1, P2, and P3 where the flexible cable 302 is not disposed. This may be because the flexible cable 302 and an injection means for the waterproof member 313 physically interfere with each other. Due to the high viscosity of the waterproof member 313 in a resin state, the injected waterproof member 313 may have limited flow due to its own weight and may not spread evenly. That is, the waterproof member 313 may be relatively more applied at the points P1, P2, and P3 where the waterproof member 313 is injected and the waterproof member 313 may be relatively less applied to a region where the flexible cable 302 is positioned. This may impair waterproof performance.

With reference to FIG. 5D, in an embodiment of the disclosure, after the waterproof member 313 is injected, the cable hole cover 320 may be assembled to press the waterproof member 313, so that the guide vane 323 may transfer the waterproof member 313 in a resin state to a region where the flexible cable 302 is positioned. Accordingly, the waterproof member 313 may be applied relatively uniformly compared to the comparative example. In addition, since the waterproof member 313 transferred under pressure by the guide vane 323 presses the flexible cable 302, the risk of separation between the layers of the flexible cable 302 having multiple layers may be reduced. As a result, waterproof failure of the foldable electronic device 300 may be reduced.

A foldable electronic device 300 according to various embodiments of the disclosure may include a hinge 309, multiple housings 310a and 310b that are coupled to each other to be rotatable by the hinge 309 and have an inner space for receiving multiple electrical components, and a flexible cable 302 that electrically and mutually connects the multiple electrical components of the housings 310a and 310b. The housings 310a and 310b may include a cable hole 311 formed to allow the flexible cable 302 to pass therethrough, a cable seal 312 that closes one side of the cable hole 311 positioned in a first direction, and a cable hole cover 320 positioned to cover the other side of the cable hole 311 positioned in a second direction opposite to the first direction, the cable hole cover 320 at least partially closing the cable hole 311 while holding the flexible cable 302 with respect to the cable hole 311.

In various embodiments, the flexible cable 302 may include a shaping portion 303 that is bent and shaped to be directed from the cable hole 311 toward a direction of the electrical component, and the cable hole cover 320 may include a cable shaping guide surface 321 that is formed on a surface of the cable hole cover 320 facing the first direction, and supports the shaping portion 303 of the flexible cable 302.

In various embodiments, a curvature radius of the cable shaping guide surface 321 may be equal to a curvature radius of the shaping portion 303 of the flexible cable 302.

In various embodiments, a cable holder 325 may be included, which includes an elastic material and holds the flexible cable 302 by pressing the flexible cable 302 against an end of the other side of the cable hole 311.

In various embodiments, the housings 310a and 310b may include a waterproof member 313 including a resin material that is at least partially filled inside the cable hole 311, and the cable hole cover 320 may be positioned to cover the resin material from the other side of the cable hole 311.

In various embodiments, the flexible cable 302 may include multiple layers.

In various embodiments, the cable hole cover 320 may include a pressing protrusion 322 that presses the resin material with respect to the first direction.

In various embodiments, the flexible cable 302 may include a shaping portion 303 that is bent and shaped to be directed from the cable hole 311 toward a direction of the electrical component, and
the cable hole cover 320,
may include a cable shaping guide surface 321 that is formed on a surface of the pressing protrusion 322 and supports the shaping portion 303 of the flexible cable 302.

In various embodiments, the housings 310a and 310b may include a screw hole 314 that is positioned around the cable hole 311 and formed in the first direction, and the cable hole cover 320 may include a fastening hole 324 formed at a position corresponding to the screw hole 314.

In various embodiments, the cable hole cover 320 may include a screw 304 that passes through the fastening hole 324 and is fastened to the screw hole 314, and the cable hole cover 320 may press the resin material by thrust generated by fastening of the screw 304 to the screw hole 314.

In various embodiments, a guide vane 323 that transfers the resin material inside the cable hole 311 in a direction in which the flexible cable 302 is positioned may be included.

In various embodiments, the guide vane 323 may be disposed with an inclination to be directed toward a region of the cable hole cover 320 that overlaps the flexible cable 302.

In various embodiments, the guide vane 323 may be positioned laterally with respect to the first direction relative to a center of the cable hole cover 320.

As a cable hole cover 320 of a foldable electronic device 300 that includes multiple housings 310a and 310b having an inner space for receiving multiple electrical components, and a flexible cable 302 that electrically and mutually connects the multiple electrical components of the housings 310a and 310b, in which the housings 310a and 310b include a cable hole 311 formed to allow the flexible cable 302 to pass therethrough, a cable seal 312 that closes one side of the cable hole 311 in a first direction, and a waterproof member 313 including a resin material that at least partially fills an interior of the cable hole 311, the cable hole cover 320 may be configured to be positioned to cover the other side of the cable hole 311 and at least partially close the cable hole 311 while holding the flexible cable 302 with respect to the cable hole 311.

In various embodiments, the flexible cable 302 may include a shaping portion 303 that is bent and shaped to be directed from the cable hole 311 toward a direction of the electrical component, and the cable hole cover 320 may include a cable shaping guide surface 321 that is formed on a surface of the cable hole cover 320 facing the first direction and supports the shaping portion 303 of the flexible cable 302.

In various embodiments, a curvature radius of the cable shaping guide surface 321 may be equal to a curvature radius of the shaping portion 303 of the flexible cable 302.

In various embodiments, a pressing protrusion 322 that presses the resin material with respect to the first direction may be included.

In various embodiments, a guide vane 323 disposed to transfer the resin material inside the cable hole 311 in a direction in which the flexible cable 302 is positioned may be included.

In various embodiments, the guide vane 323 may be disposed with an inclination to be directed toward a region of the cable hole cover 320 overlapping the flexible cable 302.

In various embodiments, the guide vane 323 may be positioned laterally with respect to the first direction relative to the center of the cable hole cover 320.

Further, the embodiments disclosed in this document disclosed in this specification and illustrated in the drawings are provided as particular examples for easily explaining the technical contents according to the embodiment disclosed in this document and helping understand the embodiment disclosed in this document, but not intended to limit the scope of the embodiment disclosed in this document. Accordingly, the scope of the various embodiments disclosed in this document should be interpreted as including all alterations or modifications derived from the technical spirit of the various embodiments disclosed in this document in addition to the embodiments disclosed herein.

## Claims

1. A foldable electronic device, comprising:
multiple housings including a hinge, coupled to each other to be rotatable by the hinge, and including an inner space for receiving multiple electrical components; and
a flexible cable configured to electrically and mutually connect the multiple electrical components of the housings,
wherein the housings comprise:
a cable hole formed to allow the flexible cable to pass therethrough;
a cable seal configured to close one side of the cable hole positioned in a first direction; and
a cable hole cover positioned to cover the other side of the cable hole positioned in a second direction opposite to the first direction, and to at least partially close the cable hole while holding the flexible cable with respect to the cable hole.

2. The foldable electronic device of claim 1, wherein the flexible cable comprises a shaping portion that is bent and shaped to be directed from the cable hole toward a direction of the electrical component, and
wherein the cable hole cover comprises a cable shaping guide surface that is formed on a surface of the cable hole cover facing the first direction and supports the shaping portion of the flexible cable.

3. The foldable electronic device of claim 2, wherein a curvature radius of the cable shaping guide surface is equal to a curvature radius of the shaping portion of the flexible cable.

4. The foldable electronic device of claim 1, comprising:
a cable holder that includes an elastic material and holds the flexible cable by pressing the flexible cable against an end of the other side of the cable hole.

5. The foldable electronic device of claim 1, wherein the housing comprise a waterproof member including a resin material that is at least partially filled inside the cable hole, and
wherein the cable hole cover is positioned to cover the resin material from the other side of the cable hole.

6. The foldable electronic device of claim 5, wherein the flexible cable comprises multiple layers.

7. The foldable electronic device of claim 5, wherein the flexible cable comprises a shaping portion that is bent and shaped to be directed from the cable hole toward a direction of the electrical component, and
wherein the cable hole cover comprises:
a pressing protrusion configured to press the resin material with respect to the first direction; and
a cable shaping guide surface formed on a surface of the pressing protrusion and supports the shaping portion of the flexible cable.

8. The foldable electronic device of claim 5, wherein the housing comprise:
a screw hole positioned around the cable hole and formed in the first direction and,
wherein the cable hole cover comprises a fastening hole formed at a position corresponding to the screw hole,
wherein the cable hole cover comprise a screw that passes through the fastening hole and is fastened to the screw hole, the cable hole cover pressing the resin material by thrust generated by fastening of the screw to the screw hole.

9. The foldable electronic device of claim 5, comprising:
a guide vane configured to transfer the resin material inside the cable hole in a direction in which the flexible cable is positioned,
wherein the guide vane is disposed with an inclination to be directed toward a region of the cable hole cover overlapping the flexible cable.

10. The foldable electronic device of claim 9, wherein the guide vane is positioned laterally with respect to the first direction relative to a center of the cable hole cover.

11. A cable hole cover of a foldable electronic device,
wherein the foldable electronic device comprises:
multiple housings including an inner space for receiving multiple electrical components, and
a flexible cable configured to electrically and mutually connect the multiple electrical components of the housings,
wherein the housings comprise:
a cable hole formed to allow the flexible cable to pass therethrough;
a cable seal configured to close one side of the cable hole in a first direction; and
a waterproof member including a resin material that at least partially fills an interior of the cable hole, and
wherein the cable hole cover is configured to be positioned to cover the other side of the cable hole and to at least partially close the cable hole while holding the flexible cable with respect to the cable hole.

12. The cable hole cover of claim 11, wherein the flexible cable comprises a shaping portion that is bent and shaped to be directed from the cable hole toward a direction of the electrical component,
wherein the cable hole cover comprises a cable shaping guide surface that is formed on a surface of the cable hole cover facing the first direction and supports the shaping portion of the flexible cable, and
wherein a curvature radius of the cable shaping guide surface is equal to a curvature radius of the shaping portion of the flexible cable.

13. The cable hole cover of claim 11, comprising:
a pressing protrusion configured to press the resin material with respect to the first direction.

14. The cable hole cover of claim 11, comprising:
a guide vane disposed to transfer the resin material inside the cable hole in a direction in which the flexible cable is positioned,
wherein the guide vane is disposed with an inclination to be directed toward a region of the cable hole cover overlapping the flexible cable.

15. The cable hole cover of claim 14, wherein the guide vane is positioned laterally with respect to the first direction relative to a center of the cable hole cover.
